# EUROPEAN PATENT SPECIFICATION

(11) **EP 0 553 593 B1**
(45) Date of publication and mention of the grant of the patent: **29.05.1996**
(21) Application number: 92810062.7
(22) Date of filing: 28.01.1992
(51) Int. Cl.: H01L 39/24

(54) **Pinning structures for superconducting films and method for making same**
Flussschlauch-Verankerungsstrukturen für supraleitende Dünnschichten und Methoden ihrer Herstellung
Structures d'ancrage des vortex pour films minces supraconducteurs et méthode pour leur fabrication

(43) Date of publication of application: 04.08.1993
(73) Proprietor: International Business Machines Corporation, Armonk, N.Y. 10504 (US)
(72) Inventor: Courtens, Eric Dr., CH-8914 Aeugst am Albis (CH); Mannhart, Jochen, Dr., CH-8800 Thalwil (CH)
(74) Representative: Barth, Carl Otto

(56) References cited:
- WO-A-90/04856
- GB-A- 2 038 532
- US-A- 4 803 310
- PATENT ABSTRACTS OF JAPAN vol. 14, no. 553 (E-1010) 7 December 1990 ; & JP-A-2 237 179
- PHYSICA C, vol. 185-189, Part III, December 1991, pp. 2007-8, Amsterdam, NL, & MATERIALS AND MECHANISMS OF SUPERCONDUCTIVITY CONFERENCE, 22-26 July 1991, Kanazawa, JP; D.G. SCHLOM et al.: "Observations of screw dislocations in sputtered YBa2Cu3O7-8 films"

## Description

This invention relates to thin films of low- and high-T_{c} superconductor materials having pinning structures for guiding the movement of magnetic flux lines, and to a method for making such pinning structures at predetermined locations. The invention is applicable to "conventional" superconductors, such as metals like lead, mercury, niobium, and aluminium, and alloys, such as the niobium alloys Nb₃ ≥ and Nb₃Sn, for example, as well as to perovskite-related materials such as, e.g. YBa₂Cu₃O_{7-δ}, and it is also of interest in the case of more anisotropic superconductors, such as Bi₂Sr₂Caₙ₋₁CuₙOₓ and TI_{1...2}Ba₂Caₙ₋₁CuₙOₓ, for example, and to organic superconductors and fullerenes.

It is well known that for high-field, high-current applications of type II superconductors, pinning sites are necessary to pin the vortices, thus preventing flux creep or flux flow from causing resistive losses within the material. Below the critical temperature T_{c}, so-called pinning centers control the maximum current density a superconductor can support without becoming electrically resistant. For current densities higher than this "critical" current density J_{c}, the superconductor material is resistive and a voltage V can develop along the superconductor. The strength of the pinning centers depends on the concentration of free charge carriers in the superconductor material and can, therefore, be controlled by the variation of the carrier concentration with an applied electrical field, for example. This effect is used in the field-effect transistor described in EP-A-0 494 580.

Candidate defects in the generation of pinning centers are point defects, line defects, planar defects, and three-dimensional inclusions. Because of the short coherence length of high-T_{c} superconductors, the latter two types of defect pinning centers can seriously degrade the critical current by considerably reducing the area available for current flow.

For the non-dissipative operation of superconductors, pinning energies significantly greater than the thermal energy (k_{B}T) are required. Measurements of the pinning energies in high-T_{c} superconductors have shown that the pinning energy decreases as the anisotropy (ξ_{ab}/ξ_{c}) increases. This has led to the conclusion (cf. T.T.M. Palstra et al., "Role of anisotropy in the dissipative behavior of high-temperature superconductors", Phys. Rev. B, Vol. 43, No. 4 (1991) pp. 3756-3759) that the use of anisotropic high-T_{c} superconductors at moderate temperatures (i.e. moderate on the scale of T_{c}) in high magnetic fields is impractical. This conclusion is based on the measurement of pinning energies in bulk-grown single-crystals of high-T_{c} superconductor compounds where point defects are believed to be the dominant pinning sites.

It is known that epitaxial films of high-T_{c} superconductors have impressive critical current densities of ≃ 6 × 10⁶ A/cm at 77 K. Chaudhari et al., in "Earlier and Recent Aspects of Superconductivity", Springer Series in Solid-State Sciences, Vol. 90, Springer-Verlag, Berlin 1990, pp. 201-207, have pointed out that for current densities of such an order of magnitude, strong pinning centers for the magnetic flux quanta are required. The authors suggested the existence of pinning sites at the location of dislocations.

By imaging epitaxial YBa₂Cu₃O_{7-δ} material with a scanning tunneling microscope, Ch. Gerber et al., "Screw dislocations in high-T_{c} films", Nature, Vol. 350 (1991) pp. 279-280, observed screw dislocations with densities of ≃10⁹/cm. The concentration of these screw dislocations exceeds that in the substrates by three to four orders of magnitude, suggesting that high dislocation densities are an intrinsic property of sputtered high-T_{c} superconductor films.

Anselmetti et al. have taught in EP-A-0 519 147 ways to increase the dislocation density in high-T_{c} superconductors through appropriate variation of the growth parameters of the superconducting layer. While their proposal advantageously influences the number of pinning sites, it has limitations since there is only a narrow range within which the growth parameters can be varied without jeopardizing the characteristics of the superconductor layer being formed. Also, the final distribution of the pinning sites within the material is random, and there is no suggestion disclosed on how to place them at predetermined locations.

A pinning structure as set forth in the precharacterizing portion of claim 1 is known from JP-A-2-237 179.

In view of the fact that the capability of superconductor films to tolerate high current densities depends on the number and density of pinning sites within the superconductor material, it is an object of the present invention to teach ways for increasing the number of pinning sites and for positioning them at predetermined locations so as to optimize the current density tolerance of the superconductor material.

In accordance with the invention, it is suggested to artificially create a plurality of non-superconducting protruding features on the substrates that are to carry the superconductor films, those protrusions being later embedded in a superconductor thin film for which they serve as pinning sites. The shape these protrusions take is not of particular importance. Depending on the way they are produced, they will take the shape of spheres, or of approximately cylindrical posts. In all cases, the intention is to limit their height to the thickness of the superconducting layer in which they are to be embedded. Once embedded, they may be regarded as inclusions in the superconducting layer.

The manufacture of the protrusions on a suitable substrate may be made with conventional deposition techniques. For example, a great variety of epitaxial methods is available which, in connection with lithographic techniques, permit those skilled in the art to form any desired kind of protrusions. If the deposition is made under scanning tunneling microscope control, or with laser-assisted techniques, it will be possible to create posts with nanometer dimensions at mutual distances in the nanometer range, i.e., with very high density. Advantageously, the posts may be made through the decomposition of gaseous metalliferous compounds, including organic gaseous compounds.

Useful techniques of this kind are described, for example, in EP-A-0 166 308 and EP-A-0 196 346 as well as in M.A. McCord et al., "Direct Deposition of 10-nm Metallic Features with the Scanning Tunneling Microscope", J. Vac. Sci. Technol. B6(6), Nov./Dec. 1988, pp. 1877 ff.: E.E. Ehrichs et al., "Direct Wiring with the Scanning Tunneling Microscope", J. Vac. Sci. Technol. A6(6), Mar/Apr 1988, pp. 540 ff.. A survey of laser-assisted manufacturing processes is contained in R.M. Osgood et al., "Laser-Induced Chemistry for Microelectronics", Science, Vol. 277 (1985) No. 4688, pp. 709-714.

It is, accordingly, another object of the present invention to provide a novel pinning structure for high-T_{c} superconductors, as well as a method for making that pinning structure, in order to overcome the disadvantages of the prior art and to design superconductor devices in which the pinning sites are distributed in predetermined numbers and at predetermined locations.

The invention is, therefore, directed to a pinning structure in superconductors having a substrate surface which carries at predetermined locations a plurality of protrusions as pinning centers, and a film of superconductor material deposited on said protrusion - carrying substrate with said plurality of protrusions being embedded in the matrix of superconducting film formed on said substrate surface, the structure being characterized by a crystalline substrate having a crystallographic surface, said protrusions consisting of a metallic, non-superconducting material of the group comprising gold, silver, niobium, aluminium, tungsten, boron, arsenic and their alloys, said protrusions having nanometer dimension and having their longitudinal axis, if any, oriented normal with respect to said crystallographic surface.

The invention further concerns a method for producing that pinning structure wherein materials for the protrusions are deposited by dissociation of a metalliferous gas atmosphere with the aid of a tunnel tip positioned at tunneling distance from the substrate surface at a plurality of predetermined locations.

Details of an embodiment of the invention as well as of the inventive method will hereafter be described by way of example and with reference to the accompanying drawings in which:
- *Fig. 1*: is a cross section through the substrate with ongrown posts in accordance with the invention;
- *Fig. 2*: shows the superconducting film deposited on the post-carrying substrate of Fig. 1;
- *Fig. 3*: is a top plan view of a high-T_{c} superconductor film with the path of the flux line movement dictated by the posts of the invention;
- *Fig. 4*: shows an application of the invention to Josephson junctions.

While the invention is generally applicable to "conventional" superconductors as represented by certain metals and some alloys, a few of which are mentioned above, as well as to the "high-T_{c}" ceramic oxide superconductors of the perovskite type, the description to follow will concentrate on the latter for reasons of their presently higher importance and to keep the description as simple as possible. Those skilled in the superconductor art will have no problems seeing the analogies.

In the majority of cases, the high-T_{c} superconductor material is to be epitaxially grown onto the(100) surface 2 of a crystalline substrate 1 consisting of a material whose lattice constant is reasonably close to the lattice constant of the superconductor material to avoid lattice defects as far as possible. The most common substrate material is strontium titanate SrTiO₃ . Other possible substrate materials include strontium ruthenate Sr₂RuO₄, manganum oxide MgO, lanthanum aluminium oxide LaAlO₃ and lanthanum gallium oxide LaGaO₃.

The high-T_{c} superconductor materials may be selected from the group comprising YBa₂Cu₃O_{7-δ} and the more anisotropic Bi₂Sr₂Caₙ₋₁CuₙOₓ and TI_{1...2}Ba₂Caₙ₋₁CuₙOₓ , for example. In these examples, 0 ≤ δ ≤ 1; 2 ≤ n ≤ 6, and 5 ≤ x ≤ 9. Other examples of suitable superconductor materials are contained in a list given below.

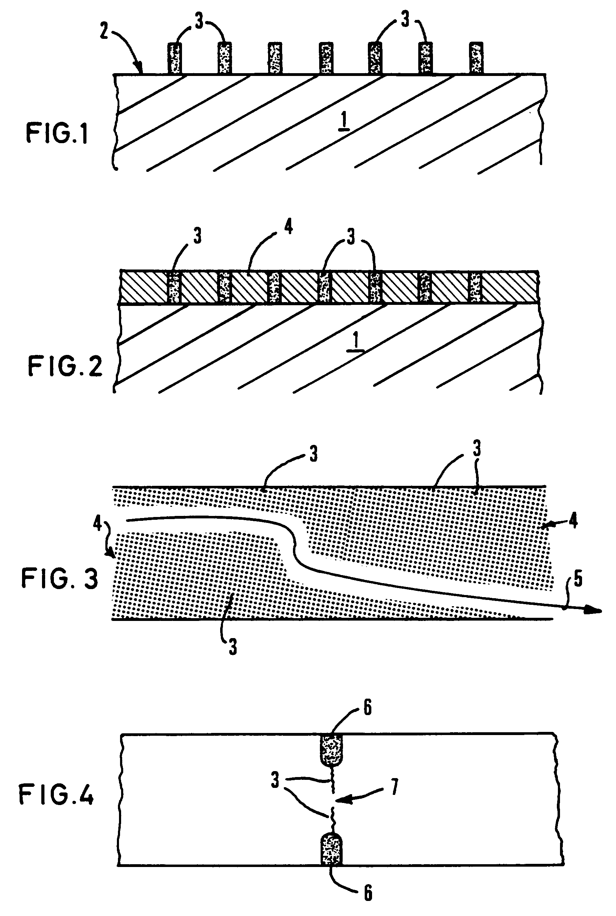

Referring to Fig. 1, the present invention starts with the preparation of a substrate 1 onto whose surface 2 at first protrusions (or posts) 3 of non-superconducting material are deposited using any of the known deposition techniques. The posts 3 may consist of metal, or of semiconductor material, or of insulating material. One might even consider making the posts of a *relatively* non-superconducting material, i.e., a superconductor material having a critical temperature T_{c} different from the one of the overlaying superconductor material.

The preferred method for making the posts 3 involves placing the substrate 1 into a vacuum chamber (such as the one described in EP-A-0 178 336, for example,) filled with a decomposable metalliferous gas which can be dissociated by the electron beam emitted by a sharply pointed tunneling tip.

Examples of gases useful for depositing metallic posts 3 include trimethylaluminium Al(CH₃)₃, tungsten hexafluoride WF₆, tungsten hexacarbonyl W(CO)₆, nickel hexacarbonyl Ni(CO)₆, boron trifluoride BF₃, disilane Si₂H₆, and arsine AsH₃. Each of these gases has a specific dissociation energy, and the parameters of the tunneling apparatus are adjusted such that the dissociation energy of the gas involved is reasonably closely matched. Of course, a combination of two or more gases may be used in the deposition of the posts 3, so that they may finally consist of alloys of the metals involved. Other metals that may be used, but of course needing different deposition techniques, are gold, silver, niobium, iron, and cobalt.

Those skilled in the art of scanning tunneling microscopy will appreciate that inside the gas-filled vacuum chamber the tunnel tip is placed over those spots on the surface 2 of substrate 1 where a post 3 is to be generated and that an electrical potential is applied across the tunneling gap. Owing to the fact that the deposition from the gas phase occurs with a tip of very small diameter, the posts 3 created will also be very thin, i.e. in the nanometer range. By xy-displacement of the tip across the surface 2 of substrate 1, a dense pattern of posts 3 can be created as required by the particular application.

Similar principles are valid for the above-mentioned laser-assisted deposition of the posts, so that a more detailed description thereof does not appear necessary here. Also, those skilled in the art will know how to produce posts of semiconductor material or of insulating material.

After the creation of the pattern of posts 3 is complete, a superconducting film 4 is deposited by standard growth techniques on the same substrate 1. As a result, the non-superconducting posts 3 are embedded in a superconducting matrix. Since the posts 3 are non-superconducting as well as very small in diameter, they form excellent pinning sites for magnetic flux quanta oriented perpendicular to the surface of superconducting film 4.

Since the discovery of the high-T_{c} copper oxide class of superconductor materials, many compounds have been investigated. The material so far best understood is YBa₂Cu₃O_{7-δ} . The following table lists other materials (including those mentioned above) that can be used in connection with the invention, together with the respective reference where a description can be found.

| Superconductor Composition | Reference |
|---|---|
| TI-Ba-Ca-CuO | EP-A-0 332 309 |
| TI-Ba-Ca-Y-CuO | EP-A-0 368 210 |
| Bi-Sr-Ca-CuO | EP-A-0 332 291 |
| | EP-A-0 362 000 |
| | EP-A-0 366 510 |
| Bi-Pb-Sr-Ba-CuO | EP-A-0 348 896 |
| Bi-Pb-Sr-Ca-CuO | EP-A-0 400 666 |
| La-Y-Bi-Sr-CuO | EP-A-0 287 810 |
| Eu-Ba-CuO | EP-A-0 310 246 |
| Yb-Ba-CuO | EP-A-0 310 247 |
| Sr-La-CuO | EP-A-0 301 958 |

For example, thin YBa₂Cu₃O_{7-δ} films (with δ between zero and 1) are preferably grown by either of the following conventional processes: DC hollow cathode magnetron sputtering or laser ablation. The sputtered films may be grown on an atomically flat polished low-index surface, such as a (100) surface, of undoped or Nb-doped SrTiO₃ substrates having a dislocation density of 1...50 × 10⁵/cm. Except for the sputter rate, which is varied by adjusting the plasma discharge between 150 V and 180 V and 260-500 mA, corresponding to growth rates between 0,01 and 0,5 nm/s, the sputtering parameters are kept at constant values as follows: Heater block temperature of 750°C, total ambient pressure (Ar/O₂ = 2:1) of 0,87 mbar, and aftergrowth cool-down in a 0,5 bar O₂ atmosphere lasting for about one hour.

Because of the high spatial resolution achievable with the known techniques, it will be possible to fabricate a plurality of elementary pinning posts 3 for magnetic flux lines on a very small area, and to place them in a well-controlled way anywhere on a given substrate 1. The structure so designed permits the guiding of the magnetic flux lines as indicated in Fig. 3. At the areas where the superconducting film 4 is penetrated by the posts 3, magnetic flux lines 5 are held in place by the strong pinning to the posts 3. Between these areas, the flux lines 5 are free to move, guided by regions of strong pinning.

These structures may be used to inject flux lines into Josephson transmission lines or, for memory applications, to move the flux lines into storage areas, or for similar purposes. Furthermore, the non-superconducting features may be used to fabricate superconducting microbridges 6 on a nanometer scale, as shown in Fig. 4. These microbridges, consisting of high-T_{c} materials, may be used as all-high-T_{c} Josephson junctions, because the width and length of the superconducting orifice 7 can be made comparable to the superconducting coherence length the of high-T_{c} compounds employed.

## Claims

1. Pinning structure in superconductors having a substrate surface (1), which carries at predetermined locations a plurality of protrusions (3) as pinning centers, and a film (4) of superconductor material deposited on said protrusion-carrying substrate (1) with said plurality of protrusions (3) being embedded in the matrix of superconducting film (4) formed on said substrate surface (2), ***characterized*** in that said substrate is crystalline and has a crystallographic surface (2), in that said protrusions (3) consist of a metallic, non-superconducting material of the group comprising gold, silver, niobium, aluminium, tungsten, boron, arsenic and their alloys, and said protrusions (3) have nanometer dimension and have their longitudinal axis, if any, oriented normal with respect to said crystallographic surface (2).

2. Pinning structure in accordance with claim 1, ***characterized*** in that the substrate (1) consists of a material of the group comprising strontium titanate SrTiO₃, strontium ruthenate Sr₂RuO₄, manganum oxide MgO, lanthanum aluminium oxide LaAlO₃ and lanthanum gallium oxide LaGaO₃.

3. Pinning structure in accordance with claim 1, ***characterized*** in that the superconductor film (4) deposited onto the protrusion-carrying substrate (1) consists of a compound of the group comprising yttrium barium copper oxide YBa₂Cu₃O_{7..δ}, wherein 0 ≤ δ ≤ 1, bismuth strontium calcium copper oxide Bi₂Sr₂Caₙ₋₁CuₙOₓ, and tantalum barium calcium copper oxide TI_{1...2}Ba₂Ca_{n..1}CuₙOₓ, wherein 2 ≤ n ≤ 6 and 5 ≤ x ≤ 9, and TIBa₂(Ca_{0,9}Y_{0,1})₃Cu₄O₁₁.

4. Method for producing a pinning structure according to claim 1, ***characterized*** in that materials for the protrusions (3) are deposited by dissociation of a metalliferous gas atmosphere with the aid of a tunnel tip positioned at tunneling distance from the substrate surface (2) at a plurality of predetermined locations.

5. Method in accordance with claim 4, ***characterized*** in that the gas/gases used for the deposition material of the protrusions is/are chosen from the group comprising trimethylaluminium Al(CH₃)₃, tungsten hexafluoride WF₆, tungsten hexacarbonyl W(CO)₆, boron trifluoride BF₃, disilane Si₂H₆, and arsine AsH₃.

## Patentansprüche

1. Verankerungsstruktur in Supraleitern mit einer Substratoberfläche (1), die an vorbestimmten Stellen eine Vielzahl von Vorsprüngen (3) als Haftzentren trägt, und einer Schicht (4) aus supraleitendem Material, die auf dem genannten Substrat (1) mit den Vorsprüngen abgeschieden wird, wobei die genannte Vielzahl von Vorsprüngen (3) in die Matrix der auf der genannten Substratoberfläche (2) gebildeten supraleitenden Schicht (4) eingebettet wird, dadurch gekennzeichnet, daß das genannte Substrat kristallin ist und eine kristallographische Fläche (2) hat, daß die genannten Vorsprünge (3) aus einem metallischen, nicht supraleitenden Material aus der Gruppe umfassend Gold, Silber, Niob, Aluminium, Wolfram, Bor, Arsen und deren Legierungen besteht, und die genannten Vorsprünge (3) Nanometer-Abmessungen haben und mit ihrer Längsachse, falls eine solche vorhanden ist, senkrecht zu der genannten kristallographischen Fläche (2) ausgerichtet sind.

2. Verankerungsstruktur nach Anspruch 1, dadurch gekennzeichnet, daß das Substrat (1) aus einem Material aus der Gruppe umfassend Strontiumtitanat, SrTiO₃, Strontiumruthenat, Sr₂RuO₄, Manganoxid, MgO, Lanthanaluminiumoxid, LaAlO₃ und Lanthangalliumoxid, LaGaO₃, besteht.

3. Verankerungsstruktur nach Anspruch 1, dadurch gekennzeichnet, daß die auf dem Substrat (1) mit den Vorsprüngen abgeschiedene supraleitende Schicht (4) aus einer Verbindung aus der Gruppe umfassend Yttriumbarium-Kupferoxid, YBa₂Cu₃O_{7-δ}, wobei 0 ≤ 1, Wismutstrontiumkalzium-Kupferoxid, Bi₂Sr₂Caₙ₋₁CuₙOₓ, und Tantalbariumkalzium-Kupferoxid, Tl_{1...2}Ba₂Caₙ₋₁CuₙOₓ, wobei 2 ≤ n ≤ 6 und 5 ≤ x ≤ 9, und TlBa₂(Ca_{0,9}Y_{0,1})Cu₄O₁₁ besteht.

4. Methode zum Erzeugen einer Verankerungsstruktur nach Anspruch 1, dadurch gekennzeichnet, daß die Materialien für die Vorsprünge (3) durch Dissoziation einer metallhaltigen Gasatmosphäre mit Hilfe einer Tunnelspitze abgeschieden werden, die im Tunnelabstand zur Substratoberfläche (2) an einer Vielzahl von vorbestimmten Stellen positioniert wird.

5. Methode nach Anspruch 4, dadurch gekennzeichnet, daß das (die) als Abscheidungsmaterial für die Vorsprünge verwendete(n) Gas(e) aus der Gruppe umfassend Trimethylaluminium, Al(CH₃)₃, Wolframhexafluorid, WF₆, Wolframhexacarbonyl, W(CO)₆, Bortrifluorid, BF₃, Disilan, Si₂H₆, und Arsin, AsH₃, ausgewählt wird/werden.

## Revendications

1. Structure de brochage dans des supraconducteurs comportant une surface (1) de substrat, qui porte en des emplacements prédéterminés une pluralité de saillies (3) sous la forme de centres de brochage, et un film (4) de matériau supraconducteur déposé sur ledit substrat (1) porteur de saillies avec ladite pluralité de saillies (3) encastrées dans la matrice du film supraconducteur (4) formé sur ladite surface (2) de substrat, **caractérisée** en ce que ledit substrat est cristallin et a une surface cristallographique (2), et ce que lesdites saillies (3) consistent en un matériau métallique non supraconducteur du groupe consistant en or, argent, niobium, aluminium, tungstène, bore, arsenic et leurs alliages, et lesdites saillies (3) ont des dimensions de l'ordre du nanomètre, et ont leur axe longitudinal, si elles en ont un, orienté normalement par rapport à ladite surface cristallographique (2).

2. Structure de brochage selon la revendication 1, **caractérisée** en ce que le substrat (1) consiste en un matériau du groupe comprenant le titanate de strontium SrTiO3, le ruthénate de strontium Sr2RuO4, l'oxyde de magnésium MgO, l'oxyde de lanthane et d'aluminium LaAlO3 et l'oxyde de lanthane et de gallium LaGaO3.

3. Structure de brochage selon la revendication 1, **caractérisée** en ce que le film supraconducteur (4) déposé sur le substrat (1) porteur de saillies consiste en un composé du groupe comprenant l'oxyde d'yttrium de baryum et de cuivre YBa2Cu3O7-δ, où 0 ≤ δ ≤ 1, de l'oxyde de bismuth de strontium de calcium et de cuivre Bi2Sr2Can-1CunOx, et de l'oxyde de tantale de baryum de calcium et de cuivre Tl1...2Ba2Can-1CunOx, où 2 ≤ n ≤ 6 et 5 ≤ x ≤ 9, et TlBa2(Ca0,9Y0,1)3Cu4O11.

4. Procédé de production d'une structure de brochage selon la revendication 1, **caractérisé** en ce que les matériaux pour les saillies (3) sont déposés par dissociation d'une atmosphère gazeuse métallifère à l'aide d'une pointe à effet tunnel disposée à une distance d'effet tunnel de la surface (2) du substrat en une pluralité d'emplacements prédéterminés.

5. Procédé selon la revendication 4, **caractérisé** en ce que le gaz ou les gaz utilisés pour le matériau de dépôt des saillies est/sont choisi(s) dans le groupe consistant en triméthylaluminium Al(CH3)3, l'hexafluorure de tungstène WF6, l'hexacarbonyle de tungstène W(CO)6, le trifluorure de bore BF3, le disilane Si2H6, et l'arsine AsH3.
